# EUROPEAN PATENT APPLICATION

(11) **EP 3 018 817 A1**
(43) Date of publication of application: **11.05.2016**
(21) Application number: 14820502.4
(22) Date of filing: 26.06.2014
(51) Int. Cl.: H02N 2/00

(54) **ELECTRICITY-GENERATING DEVICE**

(30) Priority: 05.07.2013 JP 2013141917
(71) Applicant: Mitsumi Electric Co., Ltd., Tama-shi, Tokyo 206-8567 (JP)
(72) Inventor: FURUKAWA, Kenichi, Tama-shi Tokyo 206-8567 (JP); NUMAKUNAI, Takayuki, Tama-shi Tokyo 206-8567 (JP)
(74) Representative: Solf, Annkathrin
(86) International application number: PCT/JP2014/067046
(87) International publication number: WO 2015/002069

(57) **Abstract**

A power generator 1 includes a magnetostrictive element 10, a fixing member 7 for supporting a proximal end portion of the magnetostrictive element 10, a permanent magnet 6 and a loop forming member 8 fixedly attached to the fixing member 7 through the permanent magnet 6. The power generator 1 is used in a state that the fixing member 7 is fixedly attached to a housing of a vibrating body generating vibration or the like. The magnetostrictive element 10 is supported by the fixing member 7 so that a distal end portion of the magnetostrictive element 10 can be displaced with respect to the proximal end portion of the magnetostrictive element 10. The loop forming member 8 is arranged so as not to interfere with the magnetostrictive element 10 when the distal end portion of the magnetostrictive element 10 is displaced with respect to the proximal end portion of the magnetostrictive element 10. Further, the loop forming member 8 forms a loop in cooperation with the magnetostrictive element 10 and the fixing member 7 so that lines of magnetic force generated from the permanent magnet 6 return back to the permanent magnet 6 after circulating in the loop.

## Description

### FIELD OF THE INVENTION

The present invention relates to a power generator.

### BACKGROUND ART

In recent years, there has been developed a power generator which can generate electric power by utilizing variation of magnetic permeability of a magnetostrictive rod formed of a magnetostrictive material (for example, see patent document 1).

For example, this power generator includes a pair of magnetostrictive rods arranged in parallel with each other, two coupling yokes for respectively coupling one end portions and the other end portions of the pair of magnetostrictive rods with each other, coils arranged so as to respectively surround the magnetostrictive rods, two permanent magnets respectively arranged on the two coupling yokes to apply a bias magnetic field to the magnetostrictive rods and a longitudinal back yoke arranged on the permanent magnets. The back yoke is arranged in parallel with the magnetostrictive rods. Further, each of the coupling yokes is fixedly attached to the back yoke through the permanent magnets. With this configuration, a magnetic field loop passing through the magnetostrictive rods, the coupling yokes, the permanent magnets and the back yoke is formed.

The power generator having such a configuration is used in a state that one of the coupling yokes serves as a fixed end portion fixedly attached to a base body and the other one of the coupling yokes serves as a movable end portion. When external force is applied to the other one of the coupling yokes in a direction perpendicular to an axial direction of the magnetostrictive rods in a state that the one of the coupling yokes is fixedly attached to the base body, one of the magnetostrictive rods is deformed so as to be expanded and the other one of the magnetostrictive rods is deformed so as to be contracted. At the time of the deformations of the magnetostrictive rods, stress (tensile stress or compressive stress) is caused in each magnetostrictive rod. This stress caused in each magnetostrictive rod allows density of lines of magnetic force (magnetic flux density) passing through each magnetostrictive rod (that is density of the lines of magnetic force passing through each coil) to vary. As a result of this variation of the density of the lines of magnetic force, a voltage is generated in each coil.

In such a power generator, since the coupling yokes coupled with the magnetostrictive rods are fixedly attached to the back yoke through the permanent magnets, the external force acts the back yoke and the magnetostrictive rods to deform the back yoke in the same direction as the deformations of the magnetostrictive rods when the external force is applied to the magnetostrictive rods. However, since such a back yoke generally has a higher stiffness than the magnetostrictive rods, a large part of the applied external force is consumed as energy for deforming the back yoke. Thus, in order to deform the magnetostrictive rods, it is necessary to apply external force, which is larger than force required for deforming the back yoke, to the magnetostrictive rods. Due to the reason stated above, it is necessary to apply external force, which is signifiicantly larger than force essentially required for deforming the magnetostrictive rods, to the magnetostrictive rods. This results in deterioration of power generation efficiency of the power generator.

Further, in such a power generator, a level of the deformation of the back yoke and a level of the deformations of the magnetostrictive rods responding to the applied external force are different from each other. Thus, friction occurs on contact surfaces between the permanent magnets and the back yoke and between contact surfaces between the permanent magnets and the coupling yokes. Due to this friction, a part of the applied external force is consumed as frictional energy. This is also a factor of deteriorating the power generation efficiency of the power generator.

### RELATED ART

### PATENT DOCUMENT

Patent document 1: WO 2011/158473

### SUMMARY OF THE INVENTION

### PROBLEMS TO BE SOLVED BY THE INVENTION

The present invention has been made in view of the problems mentioned above. Accordingly, it is an object of the present invention to provide a power generator which can reduce loss of applied external force and efficiently generate electric power.

### MEANS FOR SOLVING THE PROBLEMS

The above problems are achieved by the present inventions defined in the following (1) to (16).
(1) A power generator comprising:
   a permanent magnet for generating lines of magnetic force;
   a magnetostrictive element including a magnetostrictive rod through which the lines of magnetic force pass in an axial direction thereof, the magnetostrictive rod formed of a magnetostrictive material;
   a coil arranged so that the lines of magnetic force pass inside the coil in an axial direction of the coil whereby a voltage is generated in the coil due to variation of density of the lines of magnetic force; and
   at least two loop forming members for forming a loop in cooperation with the magnetostrictive element so that the lines of magnetic force generated from the permanent magnet return back to the permanent magnet after circulating in the loop, the at least two loop forming members formed of a magnetic material,
   wherein the magnetostrictive element has one end portion and the other end portion and is provided so that the other end portion can be displaced with respect to the one end portion,
   wherein the at least two loop forming members include a first loop forming member provided on the side of the other end portion of the magnetostrictive element and a second loop forming member provided on the side of the one end portion of the magnetostrictive element, and
   wherein the power generator is configured so that at least the magnetostrictive element can be displaced with respect to the permanent magnet, the first loop forming member and the second loop forming member and can be displaced differentially from the permanent magnet, the first loop forming member and the second loop forming member.
(2) The power generator according to the above (1), wherein each of the first loop forming member and the second loop forming member is configured so as not to interfere with the magnetostrictive element when the other end portion of the magnetostrictive element is displaced with respect to the one end portion of the magnetostrictive element.
(3) The power generator according to the above (2), wherein each of the first loop forming member and the second loop forming member includes a bottom plate portion arranged in parallel with the magnetostrictive element and at least one lateral plate portion extending from the bottom plate portion along a displacement direction in which the other end portion of the magnetostrictive element is displaced with respect to the one end portion of the magnetostrictive element.
(4) The power generator according to the above (3), wherein the bottom plate portion and the lateral plate portion are formed integrally with each other.
(5) The power generator according to the above (4), wherein each of the bottom plate portion and the lateral plate portion is formed by bending a plate material formed of a magnetic material with a press work, a bending work or a hammering work.
(6) The power generator according to any one of the above (3) to (5), wherein the at least one lateral plate portion contains two lateral plate portions facing to each other through the bottom plate portion and arranged so as to be separated from the magnetostrictive element, and
   wherein the two lateral plate portions are configured so that the other end portion of the magnetostrictive element is displaced with respect to the one end portion of the magnetostrictive element between the two lateral plate portions.
(7) The power generator according to the above (6), wherein a distance between each lateral plate portion and the other end portion of the magnetostrictive element is in the range of 0.01 to 0.5 mm.
(8) The power generator according to any one of the above (1) to (7), wherein the second loop forming member supports the magnetostrictive element so that the other end portion of the magnetostrictive element can be displaced with respect to the one end portion of the magnetostrictive element.
(9) The power generator according to any one of the above (1) to (8), wherein the permanent magnet is arranged between the first loop forming member and the second loop forming member so that a magnetization direction of the permanent magnet coincides with an arrangement direction in which the first loop forming member and the second loop forming member are arranged.
(10) The power generator according to any one of the above (1) to (9), wherein the coil is arranged on the outer peripheral side of the magnetostrictive rod so as to surround the magnetostrictive rod.
(11) The power generator according to any one of the above (1) to (10), wherein the magnetostrictive element further includes a beam member arranged in parallel with the magnetostrictive rod and having a function of generating stress in the magnetostrictive rod.
(12) The power generator according to the above (11), wherein the beam member is another magnetostrictive rod formed of a magnetostrictive material.
(13) The power generator according to the above (11) or (12), wherein the magnetostrictive element further includes a first block body formed of a magnetic material and coupling one end portions of the magnetostrictive rod and the beam member and a second block body formed of a magnetic material and coupling the other end portions of the magnetostrictive rod and the beam member, and
   wherein the second loop forming member is attached to the first block body with a screw to support the magnetostrictive element so that the other end portion of the magnetostrictive element can be displaced with respect to the one end portion of the magnetostrictive element.
(14) The power generator according to the above (11) or (12), wherein the magnetostrictive element further includes a first block body formed of a magnetic material and coupling one end portions of the magnetostrictive rod and the beam member and a second block body formed of a magnetic material and coupling the other end portions of the magnetostrictive rod and the beam member, and
   wherein the second loop forming member is formed integrally with the first block body to support the magnetostrictive element so that the other end portion of the magnetostrictive element can be displaced with respect to the one end portion of the magnetostrictive element.
(15) The power generator according to the above (14), wherein each of the first block body and the second loop forming member are formed by bending a plate material formed of a magnetic material with a press work, a bending work or a hammering work.
(16) The power generator according to any one of the above (1) to (15), wherein a Young's modulus of the magnetostrictive material is in the range of 30 to 100 GPa.

### EFFECTS OF THE INVENTION

According to the present invention, it is possible to provide the power generator in which the magnetostrictive element can be displaced differentially (independently) from the members forming the loop (magnetic field loop) in cooperation with the magnetostrictive element. Thus, it is possible to prevent the applied external force from being consumed by the deformations of the members forming the loop, thereby efficiently utilizing the applied external force for deforming the magnetostrictive element (magnetostrictive rods).

In addition, since the magnetostrictive element is configured so as not to interfere with the members forming the loop, it is possible to prevent loss of energy due to friction between the magnetostrictive element and the members forming the loop, thereby efficiently utilizing the applied external force for deforming the magnetostrictive element (magnetostrictive rods).

### BRIEF DESCRITION OF THE DRAWINGS

Fig. 1 is a perspective view showing a first embodiment of a power generator of the present invention.
Fig. 2 is an exploded perspective view showing the power generator shown in Fig. 1.
Fig. 3 is a planar view showing the power generator shown in Fig. 1.
Fig. 4 is a right side view showing the power generator shown in Fig. 1.
Fig. 5 is a front view showing the power generator shown in Fig. 1.
Fig. 6(a) is a view schematically showing a state that external force is applied to the power generator shown in Fig. 1 in an upper direction. Fig. 6(b) is a view schematically showing a state that external force is applied to the power generator shown in Fig. 1 in a lower direction.
Fig. 7 is a perspective view showing another structural example of the power generator of the first embodiment of the present invention.
Fig. 8 is a perspective view showing a second embodiment of the power generator of the present invention.
Fig. 9 is a planar view showing the power generator shown in Fig. 8.
Fig. 10(a) is a view schematically showing a state that external force is applied to a third embodiment of the power generator of the present invention in the upper direction. Fig. 10(b) is a view schematically showing a state that external force is applied to the third embodiment of the power generator of the present invention in the lower direction.

### DETAILED DESCRIPTION OF THE PREFERRED EMBODIMENTS

Hereinafter, description will be given to a power generator of the present invention with reference to preferred embodiments shown in the accompanying drawings.

### <First embodiment>

First, description will be given to a first embodiment of the power generator of the present invention.

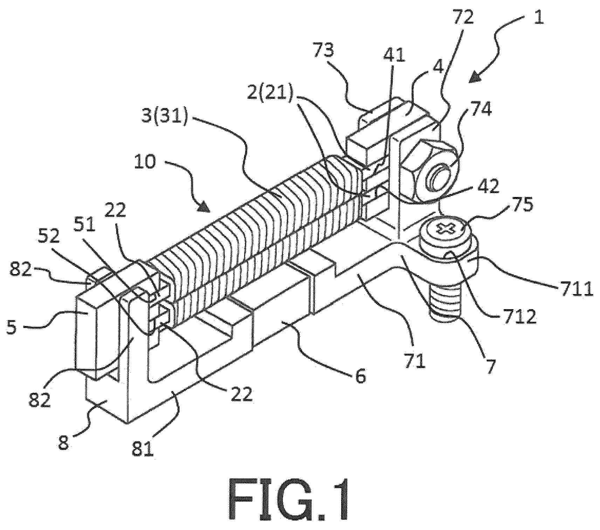

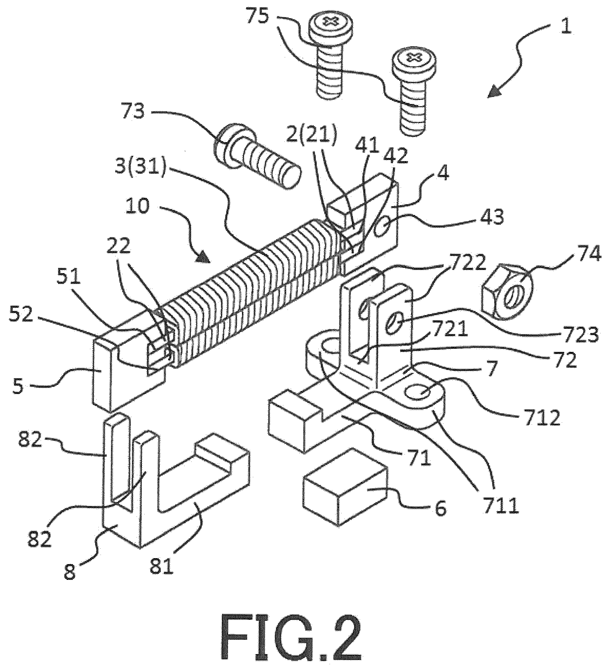

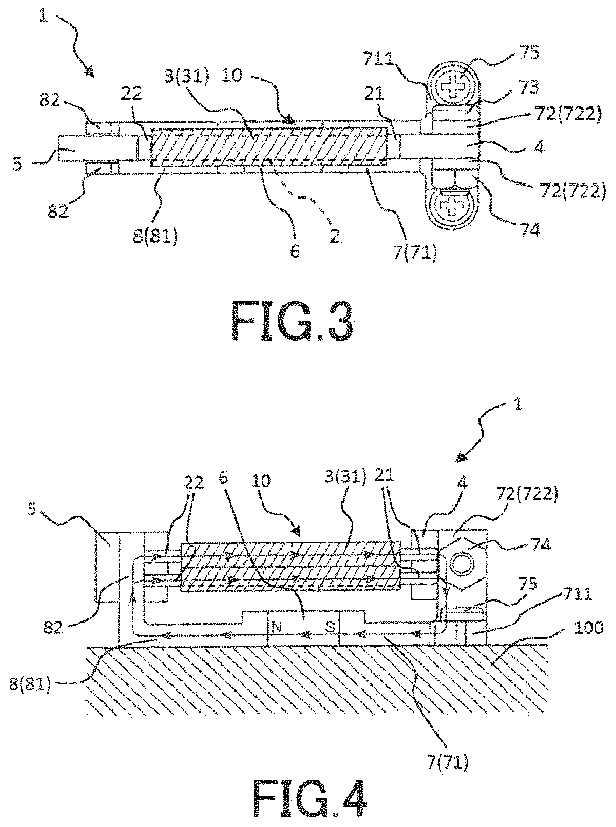

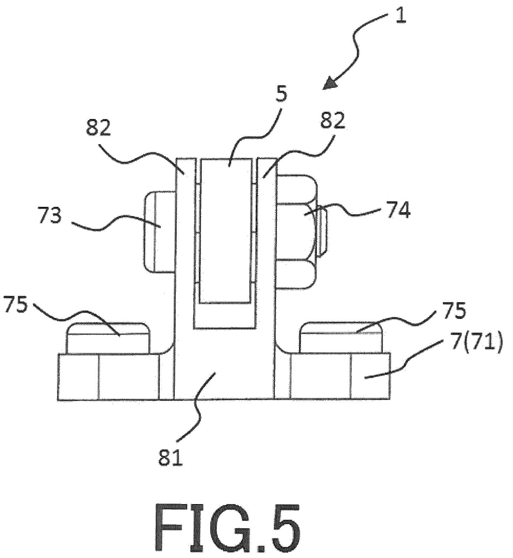

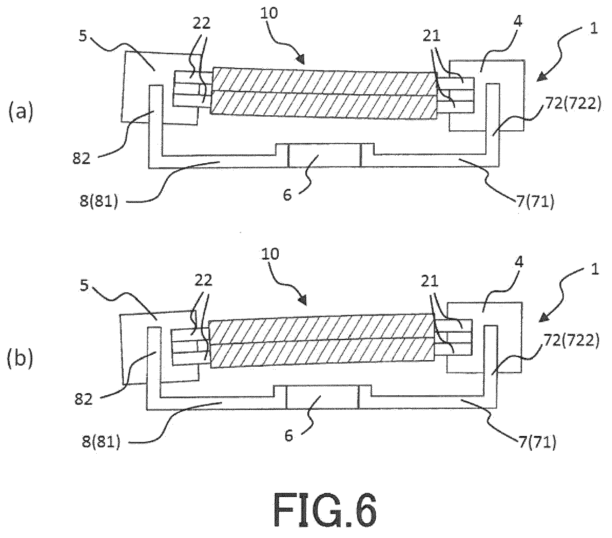

Fig. 1 is a perspective view showing the first embodiment of the power generator of the present invention. Fig. 2 is an exploded perspective view showing the power generator shown in Fig. 1. Fig. 3 is a planar view showing the power generator shown in Fig. 1. Fig. 4 is a right side view showing the power generator shown in Fig. 1. Fig. 5 is a front view showing the power generator shown in Fig. 1. Fig. 6(a) is a view schematically showing a state that external force is applied to the power generator shown in Fig. 1 in an upper direction. Fig. 6(b) is a view schematically showing a state that external force is applied to the power generator shown in Fig. 1 in a lower direction.

Hereinafter, an upper side in each of Figs. 1, 2, 4, 5, 6(a) and 6(b) and a front side of the paper in Fig. 3 are referred to as "upper" or "upper side" and a lower side in each of Figs. 1,2,4, 5, 6(a) and 6(b) and a rear side of the paper in Fig. 3 are referred to as "lower" or "lower side". Further, a left and front side of the paper in each of Figs. 1 and 2 and a left side in each of Figs. 3, 4, 6(a) and 6(b) are referred to as "distal side" and a right and rear side of the paper in each of Figs. 1 and 2 and a right side in each of Figs. 3, 4, 6(a) and 6(b) are referred to as "proximal side".

A power generator 1 shown in Figs. 1 and 2 includes a magnetostrictive element 10, a fixing member 7 for supporting a proximal end portion of the magnetostrictive element 10, a permanent magnet 6 and a loop forming member 8 provided on the opposite side of the fixing member 7 through the permanent magnet 6. The power generator 1 is used in a state that the fixing member 7 is fixedly attached to a base body such as a vibrating body generating vibration. The magnetostrictive element 10 is supported by the fixing member 7 so that a distal end portion of the magnetostrictive element 10 can be displaced with respect to the proximal end portion of the magnetostrictive element 10.

In such a power generator 1, each of the fixing member 7 and the loop forming member 8 is formed of a magnetic material. In the power generator 1, a loop (magnetic field loop) is formed so that the lines of magnetic force generated from the permanent magnet 6 return back to the permanent magnet 6 after passing through the loop forming member 8, the magnetostrictive element 10 and the fixing member 7.

Hereinafter, description will be given to each component of the power generator 1.

The magnetostrictive element 10 includes two magnetostrictive rods 2, 2 arranged in parallel with each other, coils 3 respectively wound around the magnetostrictive rods 2, a first block body 4 provided on the proximal side of the magnetostrictive rods 2 and a second block body 5 provided on the distal side of the magnetostrictive rods 2. Each of the magnetostrictive rods 2 is formed of a magnetostrictive material. The lines of magnetic force pass through the magnetostrictive rods 2 in an axial direction of the magnetostrictive rods 2.

The magnetostrictive element 10 is provided so that the magnetostrictive element 10 can be relatively displaced in a direction substantially perpendicular to the axial direction thereof (a vertical direction in Fig. 1) in a state that one end portion (proximal end portion) of the magnetostrictive element 10 on the side of the first block body 4 serves as a fixed end portion and the other end portion (distal end portion) of the magnetostrictive element 10 on the side of the second block body 5 serves as a movable end portion. This displacement in the vertical direction allows the magnetostrictive rods 2 to be deformed so as to be expanded and contracted. At this time, magnetic permeability of each magnetostrictive rod 2 varies due to an inverse magnetostrictive effect. This variation of the magnetic permeability of each magnetostrictive rod 2 leads to variation of density of the lines of magnetic force passing through the magnetostrictive rods 2 (density of the lines of magnetic force passing through the coils 3), thereby generating a voltage in the coils 3.

Each of the magnetostrictive rods 2 is formed of the magnetostrictive material as described above and arranged so that a direction in which magnetization is easily generated (an easy magnetization direction) coincides with the axial direction thereof. In this embodiment, each of the magnetostrictive rods 2 has a longitudinal plate-like shape so that the lines of magnetic force pass through the magnetostrictive rods 2 in the axial direction thereof.

A thickness (cross-sectional area) of each of the magnetostrictive rods 2 is substantially constant along the axial direction of the magnetostrictive rods 2. An average thickness of each of the magnetostrictive rods 2 is not particularly limited to a specific value, but is preferably in the range of about 0.3 to 10 mm, and more preferably in the range of about 0.5 to 5 mm. Further, an average value of the cross-sectional area of each of the magnetostrictive rods 2 is preferably in the range of about 0.2 to 200 mm², and more preferably in the range of about 0.5 to 50 mm². With such a configuration, it is possible to reliably pass the lines of magnetic force through the magnetostrictive rods 2 in the axial direction thereof.

A Young's modulus of the magnetostrictive material is preferably in the range of about 30 to 100 GPa, more preferably in the range of about 50 to 90 GPa, and even more preferably in the range of about 60 to 80 GPa. By forming the magnetostrictive rods 2 with the magnetostrictive material having the above Young's modulus, it is possible to expand and contract the magnetostrictive rod 2 more drastically. Since this allows the magnetic permeability of each of the magnetostrictive rods 2 to vary more drastically, it is possible to more improve the power generation efficiency of the power generator 1 (the coils 3).

The magnetostrictive material having the above Young's modulus is not particularly limited to a specific kind. Examples of such a magnetostrictive material include an iron-gallium based alloy, an iron-cobalt based alloy, an iron-nickel based alloy and a combination of two or more of these materials. Among them, a magnetostrictive material containing an iron-gallium based alloy (having a Young's modulus of about 70 GPa) as a main component thereof is preferably used. A Young's modulus of the magnetostrictive material containing the iron-gallium based alloy as the main component thereof can be easily adjusted to fall within the above range.

Further, it is preferred that the magnetostrictive material described above contains at least one of rare-earth metal such as Y, Pr, Sm, Tb, Dy, Ho, Er and Tm. By using the magnetostrictive material containing at least one rare-earth metal mentioned above, it is possible to make the variation of the magnetic permeability of each of the magnetostrictive rods 2 larger.

The coils 3 are respectively wound around the magnetostrictive rods 2, 2 (arranged on the outer peripheral side of the magnetostrictive rods 2, 2) so as to surround a part of each magnetostrictive rod 2, 2 except for both end portions 21, 22 (a proximal end portion 21 and a distal end portion 22) of each magnetostrictive rod 2, 2.

Each of the coils 3 is formed by winding a wire 31 around each magnetostrictive rod 2. With such a configuration, the coils 3 are provided so that the lines of magnetic force passing through the magnetostrictive rods 2 pass inside the coils 3 (inner cavities of the coils 3) in an axial direction of the coils 3 (in this embodiment, the axial direction of the coils 3 is equivalent to the axial direction of the magnetostrictive rods 2). Due to the variation of the magnetic permeability of the magnetostrictive rods 2, that is, due to the variation of the density of the lines of magnetic force (magnetic flux density) passing through the magnetostrictive rods 2, the voltage is generated in the coils 3.

A constituent material of the wire 31 is not particularly limited to a specific type. Examples of the constituent material of the wire 31 include a wire obtained by covering a copper base line with an insulating layer, a wire obtained by covering a copper base line with an insulating layer to which an adhesive (fusion) function is imparted and a combination of two or more of these wires.

The winding number of the wire 31 is not particularly limited to a specific value, but is preferably in the range of about 100 to 500, and more preferably in the range of about 150 to 450. With such a configuration, it is possible to more increase the voltage generated in the coils 3.

Further, a cross-sectional area of the wire 31 is not particularly limited to a specific value, but is preferably in the range of about 5 x 10⁻⁴ to 0.126 mm², and more preferably in the range of about 2 x 10⁻³ to 0.03 mm². Since the wire 31 with such a wire diameter of the above range has a sufficiently small resistance value, it is possible to efficiently output the electric current flowing in the coil 3 to the outside with the generated voltage. As a result, it is possible to improve the power generation efficiency of the power generator 1.

A cross-sectional shape of the wire 31 may be any shape. Examples of the cross-sectional shape of the wire 31 include a polygonal shape such as a triangular shape, a square shape, a rectangular shape and a hexagonal shape; a circular shape and an elliptical shape.

The first block body 4 is fixedly attached to the magnetostrictive rods 2 on the proximal side of the magnetostrictive rods 2. The magnetostrictive element 10 is fixedly attached to the fixing member 7 through the first block body 4.

As shown in Figs. 1 and 2, the first block body 4 has a plate-like shape. Two slits (upper slit and lower slit) 41, 42 are formed in a substantially-center portion in a height direction (a vertical direction in Fig. 2) of the first block body 4 on the distal side of the first block body 4. The proximal end portions 21 of the magnetostrictive rods 2 are respectively inserted into the slits 41, 42 and bonded to the first block body 4 with an adhesive agent or the like. Further, a through-hole 43 passing through the first block body 4 in a thickness direction thereof (a horizontal direction in Fig. 2) is formed in the first block body 4 at a position separated from the slits 41, 42 on the proximal side of the slits 41, 42.

On the other hand, the second block body 5 is fixedly attached to the magnetostrictive rods 2 on the distal side of the magnetostrictive rods 2.

The second block body 5 serves as a weight for applying external force or vibration to the magnetostrictive rods 2. When the vibrating body vibrates, external force or vibration in the vertical direction is applied to the second block body 5. By applying the external force or the vibration to the second block body 5, the magnetostrictive rods 2 begin reciprocating motion in the vertical direction in a cantilevered state that the proximal end portions 21 of the magnetostrictive rods 2 serve as fixed end portions and the distal end portions 22 of the magnetostrictive rods 2 serve as movable end portions. Namely, the distal end portions 22 of the magnetostrictive rods 2 are relatively displaced with respect to the proximal end portions 21 of the magnetostrictive rods 2.

As shown in Figs. 1 and 2, the second block body 5 has a plate-like shape. Two slits (upper slit and lower slit) 51, 52 are formed in a substantially-center portion in a height direction (the vertical direction in Fig. 2) of the second block body 5 on the proximal side of the second block body 5. The distal end portions 22 of the magnetostrictive rods 2 are respectively inserted into the slits 51, 52 and bonded to the second block body 5 with an adhesive agent or the like. The slits 51, 52 are formed so that a distance between the slits 51, 52 is substantially equal to a distance between the slits 41, 42 of the first block body 4. With this configuration, the magnetostrictive rods 2, 2 are arranged in parallel with each other with keeping a constant distance between the magnetostrictive rods 2, 2 (see Fig. 4) in a side view in a natural state of the power generator 1 (a state that external force is not applied to the magnetostrictive element 10 as shown in Fig. 4).

A constituent material of each of the first block body 4 and the second block body 5 is not particularly limited to a specific kind as long as it has an enough stiffness for reliably fixing the end portions 21, 22 of the magnetostrictive rods 2 to each block body 4, 5 and generating uniform stress in the magnetostrictive rods 2 and enough ferromagnetism for applying a bias magnetic field generated from the permanent magnet 6 to the magnetostrictive rods 2. Examples of the constituent material having the above properties include a pure iron (e.g., "JIS SUY"), a soft iron, a carbon steel, a magnetic steel (silicon steel), a high-speed tool steel, a structural steel (e.g., "JIS SS400"), a stainless, a permalloy and a combination of two or more of these materials.

Further, the distance between the slit 41 and the slit 42 of the first block body 4 is preferably in the range of about 0.3 to 10 mm, and more preferably in the range of about 0.5 to 3mm. As is the case with the distance between the slit 41 and the slit 42 of the first block body 4, the distance between the slit 51 and the slit 52 of the second block body 5 in the side view is preferably in the range of about 0.3 to 10 mm, and more preferably in the range of about 0.5 to 3 mm.

By setting the distance between the slits of each block body 4, 5 to fall within the above range, it is possible to downsize the power generator 1 and sufficiently ensure sizes of the coils 3 wound around each magnetostrictive rod 2. In the power generator 1 having such a configuration, it is possible to sufficiently ensure the sizes of the coils 3 would around each magnetostrictive rod 2. Thus, it is possible to use a wire having a relatively large diameter as the wire 31 for the coils 3 and make the winding number of the wire 31 larger. Since the wire 31 having a large diameter has a small resistance value (small load impedance), it is possible to efficiently output (utilize) the voltage generated in the coils 3. In addition, by making the winding number of the wire 31 larger, it is possible to make the voltage generated in the coils 3 larger. As a result, it is possible to improve the power generation efficiency of the power generator 1.

Further, each block body 4, 5 is designed so that a width of each block body 4, 5 (a length of each block body 4, 5 in the horizontal direction in Fig. 2) is substantially equal to a width of each magnetostrictive rod 2. The width of each block body 4, 5 is preferably in the range of about 1 to 20 mm, and more preferably in the range of about 2 to 10 mm.

In the magnetostrictive element 10 having such a configuration, the two magnetostrictive rods 2, 2 arranged in parallel with each other serve as beam members facing to each other and the magnetostrictive rods 2 are displaced in the same direction (the upper direction or the lower direction in Fig. 1) along with displacement of the second block body 5. With this configuration, one of the two magnetostrictive rods 2 serves as a beam member for generating stress in the other one of the magnetostrictive rods 2, and tensile stress or compressive stress generates in the other one of the magnetostrictive rods 2 along with the displacement of the one of the magnetostrictive rods 2. Due to this stress, the density of the lines of magnetic force passing through the magnetostrictive rods 2 varies.

Further, either one of the upper and lower magnetostrictive rods 2 in Fig. 1 may be a beam member formed of a material other than the magnetostrictive material. Such a beam member may be any member as long as it has an enough stiffness for generating stress in the other one of the magnetostrictive rods 2. Further, the beam member may be formed of a non-magnetic material. For example, the same material as the constituent material of each block body 4, 5 may be used for the beam member.

A method for fixedly attaching the end portions (the proximal end portions 21 and the distal end portions 22) of the magnetostrictive rods 2 to the slits of each block body 4, 5 is not limited to the above-mentioned bonding method with the adhesive agent. Examples of the method for fixedly attaching the end portions of the magnetostrictive rods 2 to the slits of each block body 4, 5 include a caulking method, a diffusion bonding method, a pin pressure fitting method, a brazing method and a welding method (such as a laser welding method and an electric welding method).

As described above, the first block body 4 is fixedly attached to the fixing member 7. Thus, the magnetostrictive element 10 is supported by the fixing member 7 in the cantilevered state that the distal end portion of the magnetostrictive element 10 (the second block body 5) can be displaced with respect to the proximal end portion of the magnetostrictive element 10 (the first block body 4). Further, the fixing member 7 is fixedly attached to the vibrating body. Thus, the distal end portion of the magnetostrictive element 10 can be displaced with respect to the proximal end portion of the magnetostrictive element 10 due to the vibration of the vibration body. Examples of the vibrating body to which the fixing member 7 is fixedly attached include a variety of vibrating bodies such as a pump and an air-conditioning duct. Concrete examples of the vibrating body will be described later.

The fixing member 7 described above is formed of a magnetic material and includes a base portion 71 to be fixedly attached to the vibrating body and a receiving portion 72 for receiving the first block body 4. The receiving portion 72 is provided on an upper surface of the base portion 71 on the proximal side of the base portion 71. In this embodiment, the fixing member 7 serves as a second loop forming member for forming the loop (magnetic field loop) in cooperation with the magnetostrictive element 10 and a loop forming member (first loop forming member) 8 so that the lines of magnetic force generated from the permanent magnet 6 return back to the permanent magnet 6 after circulating in the loop.

The base portion 71 includes a pair of projecting portions (bracket portions) 711 projecting from a proximal end portion of the base portion 71 toward a short direction of the proximal end portion (the horizontal direction in Fig. 2) and has a T-like shape in a planar view. The receiving portion 72 is provided in an area between the pair of projecting portions 711. The receiving portion 72 includes a bottom plate 721 and a pair of lateral plates 722 extending from the bottom plate 721 and has a U-like shape in a front (back) view. The first block body 4 is received between the pair of lateral plates 722.

The receiving portion 72 is fixedly attached to the base portion 71 with a welding method or the like so that the bottom plate 721 makes contact with the upper surface of the base portion 71 on the proximal side of the base portion 71.

A distal end portion of the base portion 71 makes contact with the permanent magnet 6. The base portion 71 is configured so that a thickness of the distal end portion of the base portion 71 is thicker than thicknesses of other portions than the distal end portion of the base portion 71. Specifically, the base portion 71 is formed so that a cross-sectional shape of the distal end portion of the base portion 71 is substantially same as a cross-sectional shape of the permanent magnet 6. With this configuration, it is possible to suppress the lines of magnetic force generated from the permanent magnet 6 from leaking from the base portion 71 (fixing member 7).

Through-holes 712 passing through the base portion 71 in a thickness direction thereof are respectively formed in the pair of projecting portions 711. By inserting male screws 75 into the through-holes 712 and screwing the male screws 75 to the vibrating body, it is possible to fixedly attach (screw-lock) the fixing member 7 to the vibrating body.

The receiving portion 72 is formed so that a distance between the pair of lateral plates 722 is substantially equal to a width of the first block body 4. Through-holes 723 passing through the lateral plates 722 in a thickness direction thereof are respectively formed in substantially center portions of the lateral plates 722. The first block body 4 is inserted between the pair of lateral plates 722 and a male screw 73 is inserted into the through-holes 723 and the through-hole 43 of the first block body 4 and screwed with a nut 74. With this configuration, the first block body 4 is screw-locked to the receiving portion 72, thereby fixedly attaching the magnetostrictive element 10 to the fixing member 7.

A method for fixedly attaching the fixing member 7 to the vibrating body or a method for fixedly attaching the magnetostrictive element 10 to the fixing member 7 is not limited to the above-mentioned screw-locking method. Examples of these methods include a bonding method with an adhesive agent, a caulking method, a diffusion bonding method, a pin pressure fitting method, a brazing method and a welding method (such as a laser welding method and an electric welding method).

A constituent material of such a fixing member 7 (the base portion 71 and the receiving portion 72) may be the same material as the above-mentioned various magnetic materials to be used for forming each block body 4, 5.

The permanent magnet 6 having a rectangular parallelepiped shape is fixedly attached to the distal end portion of the base portion 71 of the fixing member 7 due to magnetic force of the permanent magnet 6.

As the permanent magnet 6, it is possible to use an alnico magnet, a ferrite magnet, a neodymium magnet, a samarium-cobalt magnet, a magnet (a bonded magnet) obtained by molding a composite material prepared by pulverizing and mixing at least one of these magnets with a resin material or a rubber material, or the like. The permanent magnet 6 is fixedly attached to the fixing member 7 (base portion 71) on the proximal side of the permanent magnet 6 and fixedly attached to the loop forming member 8 on the distal side of the permanent magnet 6. In order to more fixedly attach the permanent magnet 6 to these components, it is possible to use a method for bonding the permanent magnet 6 to these components with an adhesive agent or the like.

As shown in Fig. 4, the permanent magnet 6 is arranged so that its south pole faces toward the right side in Fig. 4 (the side of the fixing member 7) and its north pole faces toward the left side in Fig. 4 (the side of the loop forming member 8). Namely, the permanent magnet 6 is arranged between the fixing member 7 and the loop forming member 8 so that a magnetization direction of the permanent magnet 6 coincides with an arrangement direction in which the fixing member 7 and the loop forming member 8 are arranged.

The loop forming member 8 is arranged on the distal side of the permanent magnet 6 and fixedly attached to the fixing member 7 through the permanent magnet 6.

The above-mentioned loop forming member (first loop forming member) 8 is formed of a magnetic material. The loop forming member 8 includes a bottom plate portion 81 arranged in parallel with the magnetostrictive element 10 and a pair of lateral plate portions 82 arranged on the bottom plate portion 81 on the distal side of the bottom plate portion 81 so as to face to each other through the bottom plate portion 81 and extend from the bottom plate portion 81 toward the vertical upper direction.

In this embodiment, each of the bottom plate portion 81 and the pair of lateral plate portions 82 has a belt-like shape (longitudinal plate-like shape). The bottom plate portion 81 and the pair of lateral plate portions 82 are formed so that a thickness of each lateral plate portion 82 is thinner than a thickness of the bottom plate portion 81. Although it may take a configuration in which the bottom plate portion 81 and the pair of lateral plate portions 82 are coupled with each other with a welding method or the like, it is preferable to take a configuration in which the bottom plate portion 81 and the pair of lateral plate portions 82 are formed integrally with each other.

A proximal end portion of the bottom plate portion 81 is fixedly attached to the permanent magnet 6 due to the magnetic power of the permanent magnet 6. The bottom plate portion 81 is formed so that a thickness of the proximal end portion of the bottom plate portion 81 is thicker than thicknesses of other portions than the proximal end portion of the bottom plate portion 81. Specifically, the bottom plate portion 81 is formed so that a cross-sectional shape of the proximal end portion of the bottom plate portion 81 is substantially same as the cross-sectional shape of the permanent magnet 6. With this configuration, it is possible to suppress the lines of magnetic force generated from the permanent magnet 6 from leaking from the bottom plate portion 81 (loop forming member 8).

As shown in Fig. 5, the pair of lateral plate portions 82 is designed so that a distance between the pair of lateral plate portions 82 is larger than a width of the second block body 5. The distal end portion of the magnetostrictive element 10 (the second block body 5) is positioned between the pair of lateral plate portions 82 in a state that the distal end portion of the magnetostrictive element 10 is separated from the pair of lateral plate portions 82. With this configuration, it is possible to achieve a configuration in which the distal end portion of the magnetostrictive element 10 does not make contact with the pair of lateral plate portions 82 when the distal end portion of the magnetostrictive element 10 is displaced with respect to the proximal end portion of the magnetostrictive element 10 (the first block body 4) in the vertical direction. In addition, the distal end portion of the magnetostrictive element 10 is configured so as not to make contact with the bottom plate portion 81 when the distal end portion is displaced with respect to the proximal end portion. Namely, the loop forming member 8 is configured so as not to interfere with the magnetostrictive element 10 when the distal end portion of the magnetostrictive element 10 is displaced with respect to the proximal end portion of the magnetostrictive element 10 in the vertical direction.

The meaning of the language "the loop forming member 8 does not interfere with the magnetostrictive element 10 to be displaced" in this specification also represents a configuration in which the loop forming member 8 is in a state that the loop forming member 8 makes contact with the magnetostrictive element 10 to be displaced and the displacement of the magnetostrictive element 10 is not encumbered by the loop forming member 8 in addition to the configuration in which the loop forming member 8 keeps a state that the loop forming member 8 is completely separated from the magnetostrictive element 10 to be displaced.

In the case where the loop forming member 8 is in the state that the loop forming member 8 makes contact with the magnetostrictive element 10 to be displaced and the displacement of the magnetostrictive element 10 is not encumbered by the loop forming member 8, the second block body 5 is displaced with sliding on each lateral plate portion 82 when the magnetostrictive element 10 is displaced. Thus, each of the lateral plate portions 82 serves as a guide portion for guiding the displacement of the second block body 5 in the vertical direction and can prevent the second block body 5 from being displaced in another direction (horizontal direction). Therefore, it is possible to utilize the applied external force to reliably displace the distal end portion of the magnetostrictive element 10 in the vertical direction and make an amount of the deformation of the magnetostrictive element 10 larger. As a result, it is possible to more improve the power generation efficiency of the power generator 1.

The loop forming member 8 is formed of a magnetic material. Although the loop forming member 8 is configured so as not to make contact with the second block body 5, the loop forming member 8 is arranged sufficiently close to the second block body 5. Thus, it is possible to transfer the lines of magnetic force generated from the permanent magnet 6 to the second block body 5. In other words, it is possible to apply the bias magnetic field generated from the permanent magnet 6 to the second block body 5. Therefore, in the power generator 1, it is possible to form the magnetic field loop in which the lines of magnetic force generated from the permanent magnet 6 circulates so as to return back to the permanent magnet 6 after passing through the loop forming member 8, magnetostrictive element 10 (the second block body 5, the magnetostrictive rods 2 and the first block body 4) and the fixing member 7 in a clockwise direction as shown in Fig. 4.

As shown in Fig. 4, the power generator 1 having such a configuration is fixedly attached to a housing 100 of the vibrating body by fixedly attaching the fixing member 7 to the housing 100 of the vibrating body with the male screw 75. In this state, when the second block body 5 is displaced (rotationally moved) toward the upper direction with respect to the first block body 4 due to the vibration of the vibrating body (see Fig. 6(a)), that is, when the distal end portions of the magnetostrictive rods 2 are displaced toward the upper direction with respect to the proximal end portions of the magnetostrictive rods 2, the lower magnetostrictive rod 2 is deformed so as to be expanded in the axial direction thereof and the upper magnetostrictive rod 2 is deformed so as to be contracted in the axial direction thereof. On the other hand, when the second block body 5 is displaced (rotationally moved) toward the lower direction, that is, when the distal end portions of the magnetostrictive rods 2 are displaced toward the lower direction with respect to the proximal end portions of the magnetostrictive rods 2, the lower magnetostrictive rod 2 is deformed so as to be contracted in the axial direction thereof and the upper magnetostrictive rod 2 is deformed so as to be expanded in the axial direction thereof. As a result, the magnetic permeability of each magnetostrictive rod 2 varies due to the inverse magnetostrictive effect. This variation of the magnetic permeability of each magnetostrictive rod 2 leads to the variation of the density of the lines of magnetic force passing through the magnetostrictive rods 2 (the density of the lines of magnetic force passing through the coils 3), thereby generating the voltage in the coils 3.

In the power generator 1 having such a configuration, the distal end portion of the magnetostrictive element 10 can be displaced differentially (independently) from the members (the permanent magnet 6, the fixing member 7 and the loop forming member 8) for forming the loop (magnetic field loop) in cooperation with the magnetostrictive element 10. Thus, it is possible to efficiently utilize the applied external force for the deformation of the magnetostrictive element 10 (the magnetostrictive rods 2).

Particularly, in the power generator 1, a mass of the distal end portion of the magnetostrictive element 10 contains only a mass of the second block body 5 and does not contain a mass of the permanent magnet 6 or the loop forming member 8 which is formed of a material having a relatively high specific gravity and has a relatively large mass. If such a member having a relatively large mass is coupled with the distal end portion of the magnetostrictive element and the member is deformed together with the distal end portion of the magnetostrictive element, structural damping is caused by elastic energy for deforming the coupled member and the deformation of the coupled member. As a result, the power generation efficiency deteriorates. In contrast, in the power generator 1, structural dumping caused by deformation for moving any other member than the second block body 5 does not occur. Thus, it is possible to utilize the applied external force to efficiently deform the magnetostrictive element 10.

Further, the distal end portion of the magnetostrictive element 10 can be displaced without interfering with the other members of the power generator 1. Specifically, the distal end portion of the magnetostrictive element 10 can be displaced with keeping a state that the distal end portion of the magnetostrictive element 10 does not make contact with the other members of the power generator 1. Thus, it is possible to prevent loss of energy from being caused by friction on contact surfaces among the members when the members make contact with each other at the time of the displacement of the distal end portion of the magnetostrictive element 10 or the like.

Thus, in the power generator 1, it is possible to utilize the applied external force without losing the applied external force to efficiently deform the magnetostrictive rods 2, thereby efficiently generating electric power.

Further, in the power generator 1, the mass of the distal end portion of the magnetostrictive element 10 does not contain the mass of the permanent magnet 6 or the loop forming member 8. Thus, deformation characteristics of the magnetostrictive element 10 responding to the applied external force depend on the applied external force and mechanical parameters (such as a vibrational frequency, a damping rate, a Young's modulus, a specific gravity and a cross-sectional secondary moment) of the magnetostrictive element 10. Therefore, by changing the mechanical parameters of the constituent members of the magnetostrictive element 10, it is possible to freely adjust a power generation amount of the power generator 1 and easily design the power generator 1 which can generate the electric power in a predetermined power generation amount.

Further, regarding the fixing member (the second loop forming member) 7 and the loop forming member (the first loop forming member) 8 in the power generator 1, only the fixing member 7 is fixedly attached to the vibrating body and the loop forming member 8 is not fixedly attached to the vibrating body. In such a configuration, it is unnecessary to provide a particular portion in the loop forming member 8 for fixedly attaching the loop forming member 8 to the vibrating body (for example, it is unnecessary to provide a bracket portion, a flange portion or the like having a function equivalent to the projecting portions 711 of the fixing member 7), thereby downsizing a structure of a distal end portion of the power generator 1 (making the structure of the distal end portion of the power generator 1 thinner). As a result, it is possible to reduce space for the power generator 1 (downsize the power generator 1).

Further, in such a configuration, the loop forming member 8 is vibrated in the vertical direction by the vibration of the vibrating body. By setting a natural frequency of the vibration of the loop forming member 8 to be substantially equal to a natural frequency of the vibration of the second block body 5, it is possible to cause a resonance phenomenon same as a tuning fork. With this resonance phenomenon, it is possible to suppress the vibration of the second block body 5 from decaying. Thus, the power generator 1 can utilize the external force applied from the vibrating body to more efficiently generate the electric power. Particularly, even in the case where the vibration of the vibrating body is not continuous vibration but intermittent vibration, it is possible to keep the vibration of the second block body 5 for a long term by utilizing such small vibration, thereby providing the power generator 1 having superior power generation efficiency.

Further, a large part of the lines of magnetic force generated from the permanent magnet 6 forms the magnetic field loop passing through the loop forming member 8, the magnetostrictive element 10 and the fixing member 7. On the other hand, a part of the lines of magnetic force generated from the permanent magnet 6 exists in the vicinity of the permanent magnet 6 as a leakage flux (magnetic field) to form a ferromagnetic field area.

In the power generator 1 of this embodiment, it is preferable to arrange the permanent magnet 6 so that the ferromagnetic field area of the permanent magnet 6 overlaps with the magnetostrictive rods 2 in a side view, that is, the leakage flux of the permanent magnet 6 affects the lines of magnetic force passing through the magnetostrictive rods 2. With this configuration, it is possible to uniform the density of magnetic flux in the axial direction of the magnetostrictive rods 2, thereby more improving the power generation efficiency of the power generator 1.

Specifically, a distance between the lower magnetostrictive rod 2 and the permanent magnet 6 in the natural state of the power generator 1 is preferably in the range of about 0.5 to 5 mm, and more preferably in the range of about 1 to 3 mm.

A constituent material of such a loop forming member 8 (the bottom plate portion 81 and the lateral plate portions 82) may be the same material as the above-mentioned various magnetic materials to be used for forming each block body 4, 5.

As described above, the pair of lateral plate portions 82 is designed so that the distance between the pair of lateral plate portions 82 is larger than the width of the second block body 5 and the second block body 5 is separated from each lateral plate portion 82. A distance between each lateral plate portion 82 and the second block body 5 is preferably in the range of about 0.01 to 0.5 mm, and more preferably in the range of about 0.03 to 0.2 mm. By setting the distance between each lateral plate portion 82 and the second block body 5 to fall within the above range, it is possible to sufficiently transfer the bias magnetic field generated from the permanent magnet 6 from the lateral plate portions 82 (the loop forming member 8) to the second block body 5 and more reliably prevent the magnetostrictive element 10 from making contact with the lateral plate portions 82 when the magnetostrictive element 10 is deformed.

Further, it is preferable to design the pair of lateral plate portions 82 so that an overlapping area between each lateral plate portion 82 and the second block body 5 in the side view becomes large in order to sufficiently transfer the bias magnetic field generated from the permanent magnet 6 from the pair of lateral plate portions 82 to the second block body 5. Specifically, when the overlapping area between each lateral plate portion 82 and the second block body 5 of the magnetostrictive element 10 in the natural state of the power generator 1 in the side view is defined as "S₁" and an area of a lateral surface of the second block body 5 is defined as "S₂", S₁/S₂ is preferably equal to or more than 0.1, and more preferably in the range of 0.3 to 1. By setting S₁/S₂ as described above, it is possible to reliably prevent a magnetic resistance from varying between the loop forming member 8 (the lateral plate portions 82) and the magnetostrictive element 10 (the second block body 5), thereby sufficiently applying the bias magnetic field generated from the permanent magnet 6 from the pair of lateral plate portions 82 to the second block body 5.

As described above, in the power generator 1, the vibration of the vibrating body is transferred to the members (the fixing member 7, the permanent magnet 6 and the loop forming member 8) provided on the side of the vibrating body and then the transferred vibration allows the members to be vibrated. The vibration of these members leads to the displacement of the magnetostrictive element 10. Namely, the magnetostrictive element 10 is relatively displaced with respect to these members.

The air-conditioning duct to which the power generator 1 is fixedly attached is, for example, a duct or a pipe used for forming a flow channel in a device for delivering (emitting, ventilating, inspiring, wasting or circulating) steam, water, fuel oil and gas (such as air and fuel gas). Examples of the pipe and the duct include a pipe and an air-conditioning duct installed in a big facility, building, station and the like. Further, the vibrating body is not limited to such a pipe and an air-conditioning duct. Examples of the vibrating body include a transportation (such as a freight train, an automobile and a back of truck), a crosstie (skid) for railroad, a wall panel of an express highway or a tunnel, a bridge, a vibrating device such as a pump and a turbine.

Here, the vibration of the vibrating body is unwanted vibration for delivering an objective medium (in the case of the air-conditioning duct, gas and the like passing through the duct). The vibration of the vibrating body normally results in noise and uncomfortable vibration. In the present invention, by fixedly attaching the power generator 1 to such a vibrating body, it is possible to generate electric energy in the power generator 1 by converting (regenerating) such unwanted vibration (kinetic energy).

The electric energy generated in the power generator 1 can be utilized for a power supply of a sensor, a wireless communication device and the like. In a power generating system having the power generator 1, the sensor and the wireless communication device, the sensor can get measured data such as illumination intensity, temperature, humidity, pressure, noise and the like in a facility or a residential space and then transmit the measured data to an external device through the wireless communication device. The external device can use the measured data as various control signals or a monitoring signal. Such a power generating system can be also used as a system for monitoring status of each component of vehicle (for example, a tire pressure sensor and a sensor for seat belt wearing detection). Further, by converting such unwanted vibration of the vibrating body to the electric energy in the power generator 1, it is possible to reduce the noise and the uncomfortable vibration generated from the vibrating body.

Further, by providing the power generator 1 with a mechanism for fixedly attaching the power generator 1 to a base body other than the vibrating body and a mechanism for directly applying the external force to a distal end portion of the power generator 1 (the second block body 5) and combining the power generator 1 with a wireless communication device, it is possible to obtain a switching device which can be operated by a hand. In this case, only the magnetostrictive element 10 is displaced and the members (the fixing member 7, the permanent magnet 6 and the loop forming member 8) provided on the side of the base body are not displaced. Namely, the magnetostrictive element 10 is relatively displaced with respect to the members.

Such a switching device can function without being wired for a power supply and a signal line. For example, the switching device can be used for a wireless switch for house lighting, a home security system (in particular, a system for wirelessly informing detection of operation to a window or a door) or the like.

Further, by applying the power generator 1 to each switch of a vehicle, it becomes unnecessary to wire the switch for the power supply and the signal line. With such a configuration, it is possible to reduce the number of assembling steps and a weight of a wire provided in the vehicle, thereby achieving weight saving of the vehicle or the like. This makes it possible to suppress a load on a tire, a vehicle body and an engine and contribute to safety of the vehicle.

The power generation amount of the power generator 1 is not particularly limited to a specific value, but is preferably in the range of about 20 to 2000 µJ. If the power generation amount of the power generator 1 (power generating capability of the power generator 1) is in the above range, it is possible to efficiently utilize the electric power generated by the power generator 1 for the wireless switch for house lighting, the home security system or the like described above in combination with a wireless communication device.

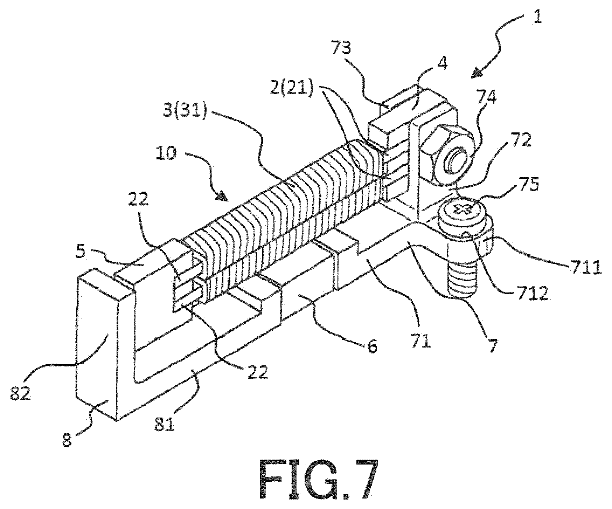

In the power generator 1 of this embodiment, although the pair of lateral plate portions 82 of the loop forming member 8 is provided so as to face to each other through the bottom plate portion 81, the present invention is not limited to this configuration as long as the bias magnetic field generated from the permanent magnet 6 can be sufficiently transferred to the second block body 5. For example, one of the lateral plate portions 82 or both of the lateral plate portions 82 may be omitted from the power generator 1 shown in Fig. 1. However, by providing the pair of lateral plate portions 82 as described in this embodiment, it is possible to make an intensity of the bias magnetic field which can be transferred to the second block body 5 sufficiently large. Further, it may take another configuration shown in Fig. 7.

Fig. 7 is a perspective view showing another structural example of the power generator of the first embodiment of the present invention.

In the power generator 1 shown in Fig. 7, the loop forming member 8 includes the bottom plate portion 81 and one lateral plate portion 82 extending from a distal end portion of the bottom plate portion 81 toward the vertical upper direction. Such a power generator 1 is configured so that the second block body 5 does not make contact with the lateral plate portion 82 when the magnetostrictive element 10 is deformed. In such a configuration, the loop forming member 8 does not interfere with the distal end portion of the magnetostrictive element 10. Thus, the configuration shown in Fig. 7 can also provide the same effects as the power generator 1 of this embodiment described above.

### <Second embodiment>

Next, description will be given to a second embodiment of the power generator of the present invention.

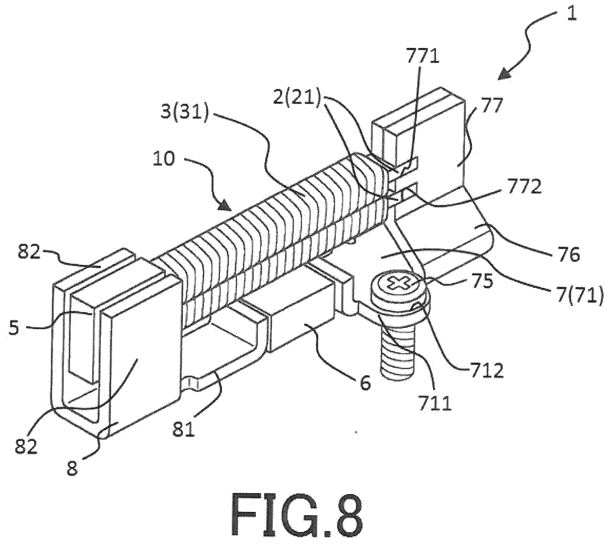

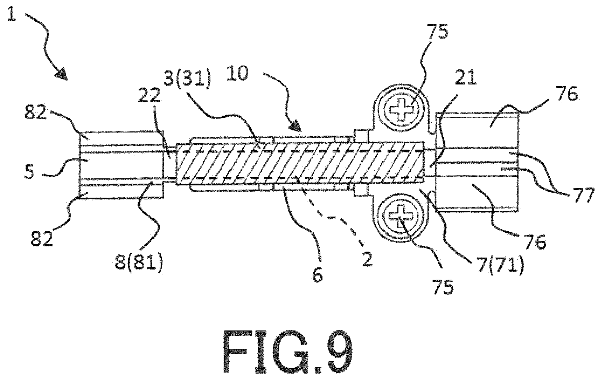

Fig. 8 is a perspective view showing the second embodiment of the power generator of the present invention. Fig. 9 is a planar view showing the power generator shown in Fig. 8.

Hereinafter, an upper side in each of Figs. 8 and 9 is referred to as "upper" or "upper side" and a lower side in each of Figs. 8 and 9 is referred to as "lower" or "lower side". Further, a left and front side of the paper in Fig. 8 and a left side in Fig. 9 are referred to as "distal side" and a right and rear side of the paper in Fig. 8 and a right side in Fig. 9 are referred to as "proximal side".

Hereinafter, the power generator according to the second embodiment will be described by placing emphasis on the points differing from the power generator according to the first embodiment, with the same matters being omitted from description.

As shown in Fig. 8, a power generator 1 of the second embodiment has the same configuration as the power generator 1 of the first embodiment except that the configurations of the fixing member (the second loop forming member) 7 and the loop forming member (the first loop forming member) 8 are modified.

Hereinafter, description will be given to each component of the fixing member 7 and the loop forming member 8.

As shown in Figs. 8 and 9, the fixing member 7 includes a base portion 71, fixing portions 77 to which the proximal end portions 21 of the magnetostrictive rods 2 should be fixedly attached and a pair of coupling portions 76 for coupling both lateral portions of the base portion 71 with lower end portions of the fixing portions 77. These components of the fixing member 7 are formed integrally with each other. Further, the base portion 71 includes a pair of projecting portions (bracket portions) 711 extending from the base portion 71 on the distal side of the base portion 71 toward a short direction of the base portion 71 (a horizontal direction in Fig. 8).

In this embodiment, the base portion 71, the coupling portions 76 and the fixing portions 77 of the fixing member 7 are formed integrally with each other. Such a fixing member 7 can be formed by preparing a substantial T-shaped plate material formed of a magnetic material and bending the T-shaped plate material with a press work, a bending work, a hammering work or the like so that the coupling portions 76 and the fixing portions 77 are bended from the base portion 71 toward the same direction and the fixing portions 77 are coupled with each other. Since such a fixing member 7 can be formed by bending one plate material with a press work or the like, it is possible to reduce the number of assemblies and the number of assembling steps for fixedly attaching the members with each other. In this regard, a distal end portion of the base portion 71 is also bended with a press work or the like.

Further, two slits (an upper slit and a lower slit) 771, 772 are formed in substantially center portions in a thickness direction of the fixing portions 77 on the distal side of the fixing portions 77 along a width direction of the fixing portions 77. The proximal end portions 21 of the magnetostrictive rods 2 are respectively inserted into the slits 771, 772 and bonded to the fixing portions 77 with an adhesive agent or fixedly attached to the fixing portions 77 with a caulking tool or the like. Namely, in this embodiment, the first block body of the magnetostrictive element 10 is constituted of the fixing portions 77.

As is the case with the loop forming member 8 of the first embodiment described above, the loop forming member 8 includes the bottom plate portion 81 and the pair of lateral plate portions 82 extending from both lateral portions of the bottom plate portion 81 on the distal side of the bottom plate portion 81 toward the vertical upper direction and facing to each other through the bottom plate portion 81. In this embodiment, the bottom plate portion 81 and the pair of lateral plate portions 82 are formed integrally with each other.

Such a loop forming member 8 can be formed by preparing a substantial T-shaped plate material formed of a magnetic material and bending the T-shaped plate material with a press work, a bending work, a hammering work or the like so that the lateral plate portions 82 are bended from the bottom plate portion 81 toward the same direction. Since such a loop forming member 8 can be formed by bending one plate material with a press work or the like, it is possible to reduce the number of assemblies and the number of assembling steps for fixedly attaching or coupling the members with each other. In this regard, the proximal end portion of the bottom plate portion 81 is also bended with a press work or the like.

A constituent material of each plate material used for forming such a fixing member 7 and a loop forming member 8 may be the same material as the above-mentioned various magnetic materials to be used for forming each block body 4, 5.

With such a power generator 1 of the second embodiment, it is also possible to provide the same results and effects as the power generator 1 of the first embodiment.

### <Third embodiment>

Next, description will be given to a third embodiment of the power generator of the present invention.

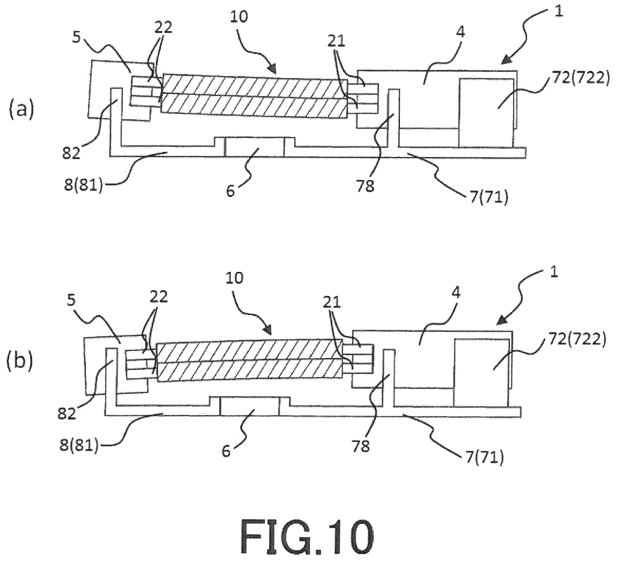

Fig. 10(a) is a view schematically showing a state that external force is applied to the third embodiment of the power generator of the present invention in the upper direction. Fig. 10(b) is a view schematically showing a state that external force is applied to the third embodiment of the power generator of the present invention in the lower direction.

Hereinafter, an upper side in each of Figs. 10(a) and 10(b) is referred to as "upper" or "upper side" and a lower side in each of Figs. 10(a) and 10(b) is referred to as "lower" or "lower side". Further, a left side in each of Figs. 10(a) and 10(b) is referred to as "distal side" and a right side in each of Figs. 10(a) and 10(b) is referred to as "proximal side".

Hereinafter, the power generator according to the third embodiment will be described by placing emphasis on the points differing from the power generators according to the first embodiment and the second embodiment, with the same matters being omitted from description.

A power generator 1 of the third embodiment has the same configuration as the power generator 1 of the first embodiment except that the configurations of the fixing member 7 and the first block body 4 of the magnetostrictive element 10 are modified.

Hereinafter, description will be given to the configurations of the fixing member 7 and the first block body 4.

As shown in Figs. 10(a) and 10(b), the first block body 4 has the same configuration as the first block body 4 of the first embodiment except that the first block body 4 is formed so that a length from a distal end to a proximal end of the first block body 4 is longer than that of the first block body 4 of the first embodiment described above. Further, in this embodiment, the through-hole 43 is formed in the vicinity of the proximal end portion of the first block body 4 and the slits 41, 42 are formed so that a distance from each slit 41, 42 to the through-hole 43 is longer than a distance from each slit 41, 42 to the through-hole 43 of the first embodiment.

The fixing member 7 includes the base portion 71, the receiving portion 72 for receiving the first block body 4 and provided on the upper surface of the base portion 71 on the distal side of the base portion 71 and a pair of lateral plate portions 78 extending from both lateral portions of a substantially-center portion in a longitudinal direction of the base portion 71 toward the vertical upper direction. As shown in Figs. 10(a) and 10(b), the fixing member 7 of this embodiment has the same configuration as the fixing member 7 of the first embodiment except that the fixing member 7 is formed so that a length of the base portion 71 in the longitudinal direction thereof is longer than that of the base portion 71 of the first embodiment and the fixing member 7 further includes the pair of lateral plate portions 78 as described above.

Each of the lateral plate portions 78 has a belt-like shape (a longitudinal plate-like shape) and is formed so that a thickness of each of the lateral plate portions 78 is thinner than a thickness of the base portion 71. Although the pair of lateral plate portions 78 may take a configuration in which the lateral plate portions 78 are coupled with the base portion 71 with a welding method or the like, it is preferable that the lateral plate portions 78 and the base portion 71 are formed integrally with each other. Each of the lateral plate portions 78 is formed of the same material (the above-mentioned various magnetic materials) as the base portion 71 and the receiving portion 72.

The pair of lateral plate portions 78 is designed so that a distance between the pair of lateral plate portions 78 is larger than the width of the first block body 4. The proximal end portion of the magnetostrictive element 10 (the first block body 4) is positioned between the pair of lateral plate portions 78 in a state that the proximal end portion of the magnetostrictive element 10 is separated from each lateral plate portion 78. With this configuration, it is possible to configure the power generator 1 so that the proximal end portion of the magnetostrictive element 10 does not make contact with the lateral plate portions 78 when the distal end portion of the magnetostrictive element 10 is displaced with respect to the proximal end portion of the magnetostrictive element 10 (the first block body 4) in the vertical direction. Namely, the pair of lateral plate portions 78 is configured so as not to interfere with the magnetostrictive element 10 when the distal end portion of the magnetostrictive element 10 is displaced with respect to the proximal end portion of the magnetostrictive element 10 in the vertical direction.

In the power generator 1 of this embodiment, a clockwise magnetic field loop is formed so that the lines of magnetic force generated from the permanent magnet 6 return back to the permanent magnet 6 after passing through the loop forming member (first loop forming member) 8, the magnetostrictive element 10, the pair of lateral plate portions 78 and the base portion 71 (closer to the distal side than the lateral plate portions 78) of the fixing member (second loop forming member) 7 in the clockwise direction. Namely, in this embodiment, the magnetic field loop is formed so that the lines of magnetic force pass through the pair of lateral plate portions 78 instead of the receiving portion 72 of the fixing member 7.

As described above, the power generator 1 of this embodiment is configured so that the loop forming member 8 (the pair of lateral plate portions 82) and the pair of lateral plate portions 78 of the fixing member 7 do not make contact with the magnetostrictive element 10 (the first block body 4 and the second block body 5). In such a configuration, a magnetic resistance on the movable side (a magnetic resistance of the loop forming member 8 and the second block body 5) is substantially equal to a magnetic resistance on the fixed side (a magnetic resistance of the fixing member 7 and the first block body 4) in the magnetic field loop formed in the power generator 1. With this configuration, it is possible to provide a good balance of magnetic flux density in a magnetic circuit including the permanent magnet 6, the loop forming member 8, the magnetostrictive element 10 and the fixing member 7, thereby more uniforming a distribution of the flow of the lines of magnetic force (the variation of magnetic flux density) on both of the fixed side and the movable side of the power generator 1. As a result, it is possible to especially improve the power generation efficiency of the power generator 1.

As is the case with the loop forming member 8, the pair of lateral plate portions 78 of the fixing member 7 keeps a state that the pair of lateral plate portions 78 is completely separated from the magnetostrictive element 10 to be displaced, but the pair of lateral plate portions 78 may take a configuration in which each of the lateral plate portions 78 is in a state that each of the lateral plate portions 78 makes contact with the magnetostrictive element 10 to be displaced and the displacement of the magnetostrictive element 10 is not encumbered by the pair of lateral plate portions 78.

In the case where the pair of lateral plate portions 78 takes the configuration in which each of the lateral plate portions 78 is in the state that each of the lateral plate portions 78 makes contact with the magnetostrictive element 10 to be displaced and the displacement of the magnetostrictive element 10 is not encumbered by the pair of lateral plate portions 78, the first block body 4 is displaced with sliding on each lateral plate portion 78 when the magnetostrictive element 10 is displaced. Thus, each of the lateral plate portions 78 serves as a guide portion for guiding the displacement of the first block body 4 in the vertical direction and can prevent the first block body 4 from being displaced in another direction (horizontal direction). Therefore, it is possible to utilize the applied external force to reliably displace the distal end portion of the magnetostrictive element 10 in the vertical direction and make the amount of the deformation of the magnetostrictive element 10 larger. As a result, it is possible to more improve the power generation efficiency of the power generator 1.

Although the power generator of the present invention has been described with reference to the accompanying drawings, the present invention is not limited thereto. In the power generator, the configuration of each component may be possibly replaced with other arbitrary configurations having equivalent functions. It may be also possible to add other optional components to the present invention.

For example, it may be also possible to combine the configurations according to the first embodiment and the second embodiment of the present invention in an appropriate manner.

Further, although the magnetostrictive rods have the rectangular cross-sectional shape in each of the embodiments, the present invention is not limited thereto. Examples of the cross-sectional shapes of the magnetostrictive rods include a circular shape, an ellipse shape and a polygonal shape such as a triangular shape, a square shape and a hexagonal.

Further, although the permanent magnet in each of the embodiment has the rectangular parallelepiped shape, the present invention is not limited thereto. Examples of the shape of the permanent magnet include a columnar shape, a plate-like shape and a triangle pole shape.

### INDUSTRIAL APPLICABILITY

According to the present invention, it is possible to provide the power generator in which the magnetostrictive element can be independently displaced with respect to the members forming the loop (magnetic field loop) in cooperation with the magnetostrictive element. Thus, it is possible to prevent the applied external force from being consumed by the deformations of the members forming the loop, thereby efficiently utilizing the applied external force for deforming the magnetostrictive element (magnetostrictive rods).

In addition, since the magnetostrictive element is configured so as not to interfere with the members forming the loop, it is possible to prevent loss of energy due to the friction between the magnetostrictive element and the members forming the loop, thereby efficiently utilizing the applied external force for deforming the magnetostrictive element (magnetostrictive rods). For the reasons stated above, the present invention is industrially applicable.

## Claims

1. A power generator comprising:
a permanent magnet for generating lines of magnetic force;
a magnetostrictive element including a magnetostrictive rod through which the lines of magnetic force pass in an axial direction thereof, the magnetostrictive rod formed of a magnetostrictive material;
a coil arranged so that the lines of magnetic force pass inside the coil in an axial direction of the coil whereby a voltage is generated in the coil due to variation of density of the lines of magnetic force; and
at least two loop forming members for forming a loop in cooperation with the magnetostrictive element so that the lines of magnetic force generated from the permanent magnet return back to the permanent magnet after circulating in the loop, the at least two loop forming members formed of a magnetic material,
wherein the magnetostrictive element has one end portion and the other end portion and is provided so that the other end portion can be displaced with respect to the one end portion,
wherein the at least two loop forming members include a first loop forming member provided on the side of the other end portion of the magnetostrictive element and a second loop forming member provided on the side of the one end portion of the magnetostrictive element, and
wherein the power generator is configured so that at least the magnetostrictive element can be displaced with respect to the permanent magnet, the first loop forming member and the second loop forming member and can be displaced differentially from the permanent magnet, the first loop forming member and the second loop forming member.

2. The power generator as claimed in claim 1, wherein each of the first loop forming member and the second loop forming member is configured so as not to interfere with the magnetostrictive element when the other end portion of the magnetostrictive element is displaced with respect to the one end portion of the magnetostrictive element.

3. The power generator as claimed in claim 2, wherein each of the first loop forming member and the second loop forming member includes a bottom plate portion arranged in parallel with the magnetostrictive element and at least one lateral plate portion extending from the bottom plate portion along a displacement direction in which the other end portion of the magnetostrictive element is displaced with respect to the one end portion of the magnetostrictive element.

4. The power generator as claimed in claim 3, wherein the bottom plate portion and the lateral plate portion are formed integrally with each other.

5. The power generator as claimed in claim 4, wherein each of the bottom plate portion and the lateral plate portion is formed by bending a plate material formed of a magnetic material with a press work, a bending work or a hammering work.

6. The power generator as claimed in any one of claims 3 to 5, wherein the at least one lateral plate portion contains two lateral plate portions facing to each other through the bottom plate portion and arranged so as to be separated from the magnetostrictive element, and
wherein the two lateral plate portions are configured so that the other end portion of the magnetostrictive element is displaced with respect to the one end portion of the magnetostrictive element between the two lateral plate portions.

7. The power generator as claimed in claim 6, wherein a distance between each lateral plate portion and the other end portion of the magnetostrictive element is in the range of 0.01 to 0.5 mm.

8. The power generator as claimed in any one of claims 1 to 7, wherein the second loop forming member supports the magnetostrictive element so that the other end portion of the magnetostrictive element can be displaced with respect to the one end portion of the magnetostrictive element.

9. The power generator as claimed in any one of claim 1 to 8, wherein the permanent magnet is arranged between the first loop forming member and the second loop forming member so that a magnetization direction of the permanent magnet coincides with an arrangement direction in which the first loop forming member and the second loop forming member are arranged.

10. The power generator as claimed in any one of claims 1 to 9, wherein the coil is arranged on the outer peripheral side of the magnetostrictive rod so as to surround the magnetostrictive rod.

11. The power generator as claimed in any one of claims 1 to 10, wherein the magnetostrictive element further includes a beam member arranged in parallel with the magnetostrictive rod and having a function of generating stress in the magnetostrictive rod.

12. The power generator as claimed in claim 11, wherein the beam member is another magnetostrictive rod formed of a magnetostrictive material.

13. The power generator as claimed in claim 11 or 12, wherein the magnetostrictive element further includes a first block body formed of a magnetic material and coupling one end portions of the magnetostrictive rod and the beam member and a second block body formed of a magnetic material and coupling the other end portions of the magnetostrictive rod and the beam member, and
wherein the second loop forming member is attached to the first block body with a screw to support the magnetostrictive element so that the other end portion of the magnetostrictive element can be displaced with respect to the one end portion of the magnetostrictive element.

14. The power generator as claimed in claim 11 or 12, wherein the magnetostrictive element further includes a first block body formed of a magnetic material and coupling one end portions of the magnetostrictive rod and the beam member and a second block body formed of a magnetic material and coupling the other end portions of the magnetostrictive rod and the beam member, and
wherein the second loop forming member is formed integrally with the first block body to support the magnetostrictive element so that the other end portion of the magnetostrictive element can be displaced with respect to the one end portion of the magnetostrictive element.

15. The power generator as claimed in claim 14, wherein the first block body and the second loop forming member are formed by bending a plate material formed of a magnetic material with a press work, a bending work or a hammering work.

16. The power generator as claimed in any one of claims 1 to 15, wherein a Young's modulus of the magnetostrictive material is in the range of 30 to 100 GPa.
